# EUROPEAN PATENT APPLICATION

(11) **EP 2 629 388 A1**
(43) Date of publication of application: **21.08.2013**
(21) Application number: 11832403.7
(22) Date of filing: 27.09.2011
(51) Int. Cl.: H02J 7/00, G01R 31/36, H01M 2/10, H01M 10/44, H01M 10/48

(54) **POWER MANAGEMENT SYSTEM**

(30) Priority: 15.10.2010 JP 2010232985
(71) Applicant: Sanyo Electric Co., Ltd., Osaka 570-8677 (JP)
(72) Inventor: SAKAI Souichi, Moriguchi-shi Osaka 570-8677 (JP); OKUDA Yasuo, Moriguchi-shi Osaka 570-8677 (JP); IWASAKI Toshiya, Moriguchi-shi Osaka 570-8677 (JP)
(74) Representative: Metzler, Volker
(86) International application number: PCT/JP2011/072047
(87) International publication number: WO 2012/049965

(57) **Abstract**

Provided is a power management system, wherein charging/discharging is conducted while reliably preventing overcharging/over-discharging, and charging/discharging control of a storage-battery system (22) comprising a plurality of storage battery units is conducted. An overall storage-battery-unit management unit (16) detects voltages of storage-battery packs composing the storage-battery system (22), voltages of unit cells composing the storage-battery packs, and serial voltages of the storage battery units (24), each of which comprises a plurality of storage-battery packs connected in series. Charging is stopped when either of these voltages exceeds an upper limit value, and discharging is stopped when either of these voltages is less than a lower limit value.

## Description

### TECHNICAL FIELD

The present invention relates to an electrical power management system, and more particularly to a system for controlling charging and discharging of a storage battery.

### BACKGROUND ART

In management of electrical power, it is preferable to generate power and feed power according to an amount of power consumption of a load. The below-listed Patent Literature 1 discloses, as a power supply system of a network system, a structure having a plurality of solar photovoltaic power supply systems connected to a communication line, and an information source device which measures weather information such as an amount of insolation and transmits the information to the solar photovoltaic power supply systems.

Meanwhile, an electricity storage device comprising a lithium-ion battery and the like is used for storing electrical power generated by solar photovoltaic power generation and for handling a varying amount of power consumption by the load. The below-listed Patent Literature 2 discloses a management device for a lithium-ion battery in which a state of charge and discharge of a lithium-ion battery is judged based on a measurement value of a charging and discharging current of the lithium-ion battery, a measurement value of the temperature, and information of power supply from a commercial power supply, to thereby calculate a remaining capacity of the lithium-ion battery.

### Citation List

### Patent Literatures

Patent Literature 1: JP 2008-136259 A
Patent Literature 2: JP 2006-140094 A

### SUMMARY OF INVENTION

### Technical Problem

Lithium-ion batteries and other secondary batteries which constitute an electricity storage device have an inter-terminal voltage of a unit storage battery which is generally referred to as a unit cell, of approximately 1V to 4V, and have a relatively small capacity. Thus, it is necessary to form a storage battery pack using a plurality of unit cells, and further to use a plurality of storage battery packs to form an electricity storage device.

If a plurality of storage battery packs are used in this manner, individual differences become obvious among the storage battery packs as charge and discharge cycles are repeated, and variations in characteristics of the plurality of storage battery packs may occur, even if the environment of usage is identical. Accordingly, in order to use storage batteries efficiently in an electrical power management system, it is necessary to assume that variations in characteristics occur among the plurality of storage battery packs and to control charging and discharging in consideration of the variations in the characteristics. In particular, in a layered structure where the electricity storage device is composed of a plurality of storage battery packs, and the storage battery pack is composed of a plurality of unit cells, as described above, it is also desirable to detect an abnormality without fail and carry out charge and discharge control, even if the abnormality occurs in one of the layers. For example, if an abnormality occurs in a connection state of the plurality of unit cells, the storage battery pack cannot fulfill its original function as a storage battery pack, and overcharge and overdischarge may occur, even if there is no abnormality in the unit cells.

The purpose of the present invention is to provide a system that can reliably prevent the electricity storage device from being overcharged and overdischarged.

### Solution to Problem

According to one aspect of the present invention, there is provided an electrical power management system for controlling charging and discharging of an electricity storage section which is charged with power from a power source and discharges the stored power to a load. In this system, the electricity storage section comprises a plurality of storage battery packs connected to each other in series, and the storage battery pack comprises a plurality of unit cells connected to each other in series. The electrical power management system comprises a detection section which detects voltages of the unit cells and voltages of the storage battery packs, and a control section which compares the detected voltages of the unit cells and the detected voltages of the storage battery packs with upper limit values and lower limit values, and suspends charging process of the electricity storage section when at least one of the voltages of the unit cells and the voltages of the storage battery packs exceeds the upper limit values, and suspends discharging process of the electricity storage section when at least one of the voltages of the unit cells and the voltages of the storage battery packs is smaller than the lower limit values.

According to another aspect of the present invention, the storage battery pack comprises m (m is an integer greater than or equal to 2) unit cells connected to each other in series, and the control section compares the voltages of the unit cells with the upper limit value and the lower limit value, and compares a voltage which is obtained by dividing the voltages of the storage battery packs by m with the upper limit value and the lower limit value.

According to another aspect of the present invention, there is provided an electrical power management system for controlling charging and discharging of an electricity storage section which is charged with power from a power source and discharges the stored power to a load. In this system, the electricity storage section comprises a plurality of storage battery packs connected to each other in series, and the storage battery pack comprises a plurality of unit cells connected to each other in series. The electrical power management system comprises a detection section which detects voltages of the unit cells and a series voltage of the storage battery packs connected in series, and a control section which compares the detected voltages of the unit cells and the detected series voltage with upper limit values and lower limit values, and suspends a charging process of the electricity storage section when at least one of the voltages of the unit cells and the series voltage exceeds the upper limit value, and suspends a discharging process of the electricity storage section when at least one of the voltages of the unit cells and the series voltage is smaller than the lower limit value.

According to another aspect of the present invention, the electricity storage section comprises n (n is an integer greater than or equal to 2) storage battery packs connected to each other in serial, and the storage battery pack comprises m (m is an integer greater than or equal to 2) unit cells connected to each other in series, and the control section compares the voltages of the unit cells with the upper limit value and the lower limit value, and compares a voltage which is obtained by dividing the series voltage by m*n with the upper limit value and the lower limit value.

According to another aspect of the present invention, there is provided an electrical power management system for controlling charging and discharging of an electricity storage section which is charged with power from a power source and discharges the stored power to a load. In this system, the electricity storage section comprises a plurality of storage battery packs connected to each other in series, and the storage battery pack comprises a plurality of unit cells connected to each other in series. The electrical power management system comprises a detection section which detects voltages of the storage battery packs and a series voltage of the storage battery packs connected in series, and a control section which compares the detected voltages of the storage battery packs and the detected series voltage with upper limit values and lower limit values, and suspends a charging process of the electricity storage section when at least one of the voltages of the storage battery packs and the series voltage exceeds the upper limit values, and suspends discharging a process of the electricity storage section when at least one of the voltages of the storage battery packs and the series voltage is smaller than the lower limit values.

According to another aspect of the present invention, the electricity storage section comprises n (n is an integer greater than or equal to 2) storage battery packs connected to each other in series, and the storage battery pack comprises m (m is an integer greater than or equal to 2) unit cells connected to each other in series, and the control section compares a voltage which is obtained by dividing the voltages of the storage battery packs by m with the upper limit value and the lower limit value, and compares a voltage which is obtained by dividing the series voltage by m*n with the upper limit value and the lower limit value.

According to another aspect of the present invention, there is provided an electrical power management system for controlling charging and discharging of an electricity storage section which is charged with power from a power source and discharges the stored power to a load. In this system, the electricity storage section comprises a plurality of storage battery packs connected to each other in series, and the storage battery pack comprises a plurality of unit cells connected to each other in series. The electrical power management system comprises a detection section which detects voltages of the unit cells, voltages of the storage battery packs, and a series voltage of the storage battery packs connected in series, and a control section which compares the detected voltages of the unit cells, the detected voltages of the storage battery packs, and the detected series voltage with upper limit values and lower limit values, and suspends a charging process of the electricity storage section when at least one of the voltages of the unit cells, the voltages of the storage battery packs, and the series voltage exceeds the upper limit values, and suspends a discharging process of the electricity storage section when at least one of the voltages of the unit cells, the voltages of the storage battery packs, and the series voltage is smaller than the lower limit values.

According to another aspect of the present invention, the electricity storage section comprises n (n is an integer greater than or equal to 2) storage battery packs connected to each other in series, and the storage battery pack comprises m (m is an integer greater than or equal to 2) unit cells connected to each other in series. The control section compares the voltages of the unit cells with the upper limit value and the lower limit value, compares a voltage which is obtained by dividing the voltages of the storage battery packs by m with the upper limit value and the lower limit value, and compares a voltage which is obtained by dividing the series voltage by m*n with the upper limit value and the lower limit value.

### Advantageous Effects of Invention

With the present invention, it is possible to reliably prevent the electricity storage section from being overcharged and overdischarged.

### BRIEF DESCRIPTION OF DRAWINGS

[FIG.1] FIG. 1 shows a basic structural diagram of an electrical power management system.
[FIG. 2] FIG. 2 shows an internal structural diagram of a storage battery pack.
[FIG. 3] FIG. 3 shows an internal structural diagram of an electricity storage section.
[FIG. 4A] FIG. 4A shows an overall process flowchart (part 1) for charge and discharge control.
[FIG. 4B] FIG. 4B shows an overall process flowchart (part 2) for charge and discharge control.
[FIG. 5] FIG. 5 shows a time sequential explanatory diagram during charging.
[FIG. 6] FIG. 6 shows a time sequential explanatory diagram during discharging.
[FIG. 7] FIG. 7 shows a calculation flowchart of a SOC.
[FIG. 8] FIG. 8 shows a timing chart showing a calculation method of a SOC.

### DESCRIPTION OF EMBODIMENTS

An embodiment of the present invention will now be described below with reference to the drawings.

### 1. Basic Structure of the System

First, a basic structure of an electrical power management system according to the present embodiment will be described.

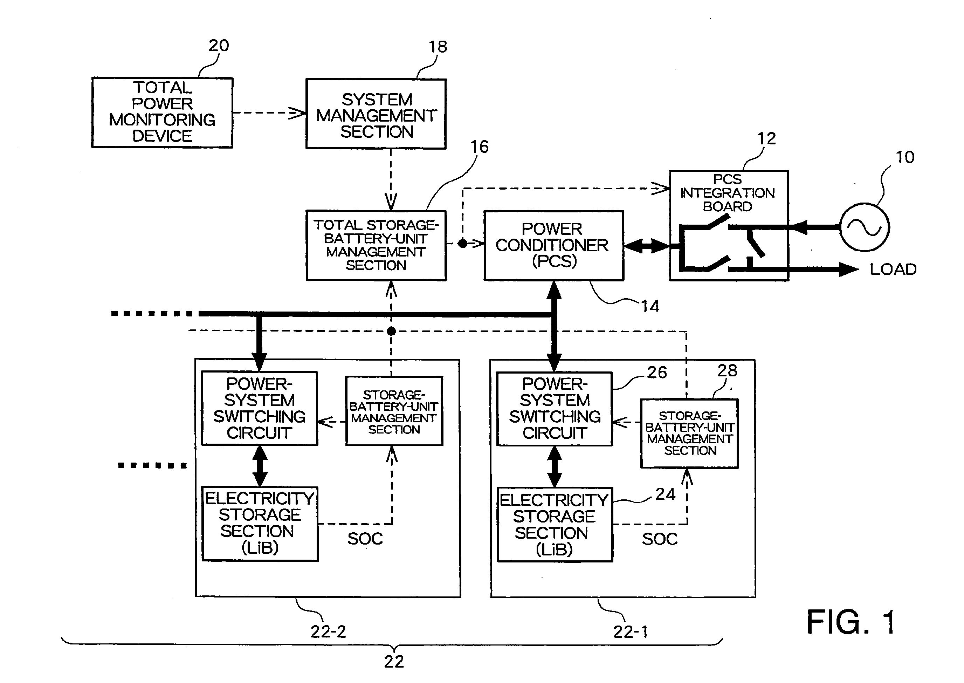

FIG. 1 shows an overall structural diagram of an electrical power management system according to the present embodiment. The electrical power management system includes a PCS integration board 12 to which power is fed from an external commercial power supply 10, a power conditioner (PCS) 14, a total storage-battery-unit management section 16, a system management section 18, a total power monitoring device 20, and a storage battery system 22. This electrical power management system is installed in plant facilities, etc., in order to supply power required by the loads of general lighting, general air conditioning, kitchen equipment, business equipment such as servers and personal computers. Power may be supplied to these loads such that all power is supplied from this electrical power management system only or such that this electrical power management system is used together with the external commercial power supply.

The external commercial power supply 10 is a single-phase or three-phase AC power source to which power is supplied from an external electrical power company such that power generated by various power generation methods, such as thermal power generation, hydroelectric power generation, and nuclear power generation, is combined together.

The PCS integration board 12 switches a connection between the external commercial power supply 10 and the storage battery system 22. More specifically, during charging or discharging, the PCS integration board 12 turns on a switch to connect between an AC system of the external commercial power supply 10 and the storage battery system 22, while, when charging and discharging is prohibited, it turns off the switch to cut off the connection between the AC system of the external commercial power supply 10 and the storage battery system 22. If the switch of the PCS integration board 12 connects between the AC system of the external commercial power supply 10 and the storage battery system 22, and if the potential of the storage battery system 22 is higher than that of the external commercial power supply 12, electrical power stored in the storage battery system 22 is discharged, while if the potential of the storage battery system 22 is lower than that of the external commercial power supply 12, the external commercial power supply 12 charges the storage battery system 22. The PCS integration board 12 is controlled to be switched by a control instruction from the total storage-battery-unit management section 16 and outputs a charging or discharge instruction to the power conditioner 14 based on the control instruction from the total storage-battery-unit management section 16.

The power conditioner 14 has an interactive AC-DC converter and, during charging, it converts AC power from the external commercial power source 10 to DC power and supplies the resulting power to the storage battery system 22, while, during discharging, it converts DC power from the storage battery system 22 to AC power and supplies the resulting power to the AC load. Alternatively, the power conditioner 14 may have a DC-DC converter (not shown) on the DC system side, and convert, during discharging, DC power from the storage battery system 22 to relatively low voltage DC power and supply the resulting power to the DC load. The power conditioner 14 is provided common to a plurality of storage battery systems 22 and carries out power conversion of these storage battery systems 22 in a collective manner. There may be one or more power conditioners 14, and each of a plurality of power conditioners controls a plurality of storage battery system 22 in a collective manner. The one or more power conditioners 14 are controlled by control instructions from the PCS integration board 12.

The total storage-battery-unit management section 16 judges, based on a charge and discharge control instruction from the system management section 18 and data from the electricity storage units 22-1, 22-2, ... of the storage battery system 22, whether the charge and discharge control instruction from the system management section 18 can be executed without change, and outputs a charge instruction or discharge instruction to the power conditioner 14 based on the judgment result, while outputting a charge instruction or discharge instruction to the storage-battery-unit management sections 28 of the electricity storage units 22-1, 22-2, .... The total storage-battery-unit management section 16 judges whether or not to perform charging or discharging according to a state of charge and voltage in the electricity storage units 22-1, 22-2, .... This processing will be further described below.

The system management section 18 outputs the charge and discharge control instruction to the total storage-battery-unit management section 16 based on management information from the total power monitoring device 20. More specifically, the total power monitoring device 20 obtains data relating to power required on the load side and power on the storage battery side, and outputs the management information. The system management section 18 judges whether to charge or discharge the storage battery system 22 based on this management information, and outputs the charge and discharge control instruction. The charge and discharge control instruction may indicate charge and discharge conditions using a power value and a time period, such as "charge at **kW for **seconds" or "discharge at **kW for **seconds", or may indicate charge and discharge conditions using a power value and end voltage or SOC, such as "charge (discharge) at **kW until voltage becomes **V" or "charge (discharge) at **kW until a SOC becomes **%". For example, in order to prevent peak electrical power of the external commercial power supply 10 from being excessive due to a varying amount of power consumption by the load, the system management section 18 schedules charging and discharging so as to smooth power of the external commercial power supply 10 by converting, prior to a time when the peak electrical power is expected, AC power from the external commercial power supply 10 to DC power and charging the storage battery system 22, and then discharging power from the electricity storage device 22 to the load at the time of peak electrical power. The charge and discharge control instruction from the system management section 18 is output to the total storage-battery-unit management section 16 irregularly at necessary times. Therefore, the present electrical power management system transits among three states, that is, a charging state at a certain point in time, a discharging state at another point in time, and a waiting state at still another point in time where neither charging or discharging is performed.

The storage battery system 22 is composed of a plurality of electricity storage units 22-1, 22-2, ..., such as five electricity storage units 22-1, 22-2, ..., 22-5. The electricity storage units 22-1, 22-2, ... have the same structure. Referring to a storage unit 22-1 as an example, the storage unit 22-1 includes an electricity storage section 24, a power-system switching circuit 26, and a storage-battery-unit management section 28.

The electricity storage section 24 is composed of a plurality of storage battery packs, and each storage battery pack is composed of a plurality of unit cells. The unit cell is composed of a lithium-ion secondary battery. The structure of the electricity storage section 24 will be further described later.

The power-system switching circuit 26 is a circuit for switching between charging and discharging. When the storage battery system 22 is charged, a charge switch is turned on, while a discharge switch is turned off. When the storage battery system 22 is discharged, the charge switch is turned off, while the discharge switch is turned on. ON and OFF of the charge switch and the discharge switch is controlled by an instruction from the storage-battery-unit management section 28.

The storage-battery-unit management section 28 receives, as a state of charge, data such as a charge percentage SOC from each storage battery pack of a plurality of storage battery packs constituting the electricity storage section 24, and outputs the data such as the charge percentage SOC to the total storage-battery-unit management section 16. Here, a SOC is a parameter indicating a ratio of dischargeable capacity with respect to a fully charged capacity (remaining capacity) in percentage. The total storage-battery-unit management section 16 judges whether or not it is possible to perform charging or discharging based on the data such as SOCs supplied from the respective storage-battery-unit management sections 28 of the electricity storage units 22-1, 22-2, ..., and 22-5, and instructs the storage-battery-unit management sections 28 of the electricity storage units 22-1, 22-2, ..., and 22-5 to perform charging or discharging based on the determination results. In response to this charge or discharge instruction, the storage-battery-unit management section 28 controls the charge switch to be turned on when it is a charge instruction, and controls the discharge switch to be turned on when it is a discharge instruction.

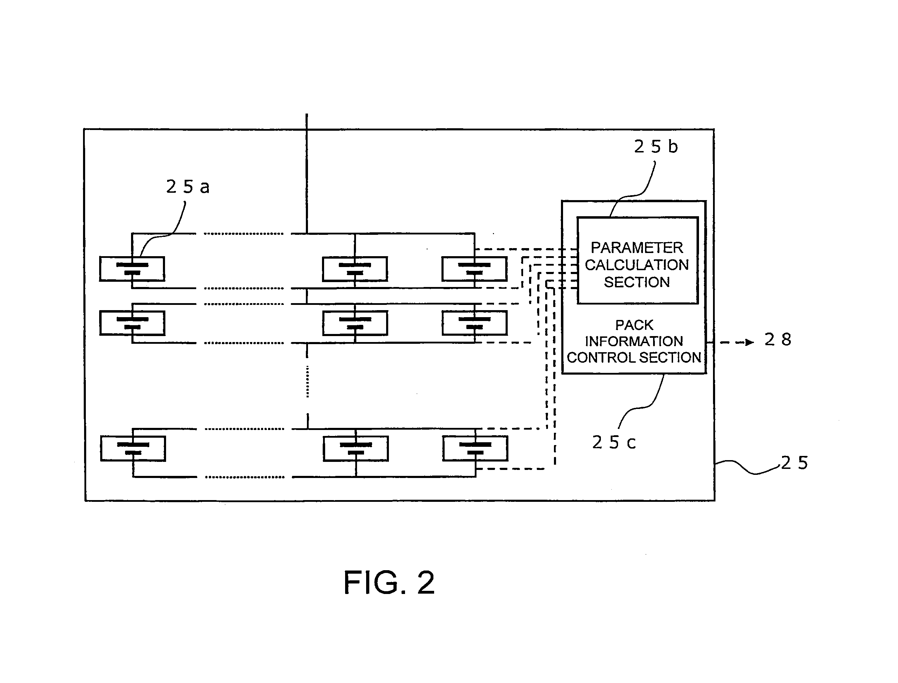

FIG. 2 shows an internal structure of the storage battery pack 25 constituting the electricity storage section 24. The storage battery pack 25 is configured such that a plurality of lithium-ion unit cells 25a are connected in series and in parallel. For example, the storage battery pack 25 is configured such that 24 unit cells 25a are connected in parallel, and these 13 parallel connections are connected in series. The storage battery pack 25 is composed of, in addition to these plurality of unit cells 25a, a pack information control section 25c having a parameter calculation section 25b.

The parameter calculation section 25b measures a current value and a voltage value of each stage in which the unit cells are connected in parallel, measures a current value and a voltage value between positive and negative electrodes of the storage battery pack, a SOC of the storage battery pack, and temperature for each storage battery pack, and outputs the results to the pack information control section 25c. The SOC can be calculated from an integrated value of charging or discharging currents and also can be calculated by referring to an equation or a table indicating a predetermined relationship between open-end voltage and a SOC. The method of calculating the SOC will be further described below. Because the storage battery pack has an internal resistance and an internal capacitance, there may be cases where the open-end voltage cannot be calculated accurately. There may be cases where a dischargeable capacity cannot be calculated. It is possible to judge the SOC indicating a dischargeable capacity more accurately by selectively using or combining the above-described SOC calculation techniques according to circumstances.

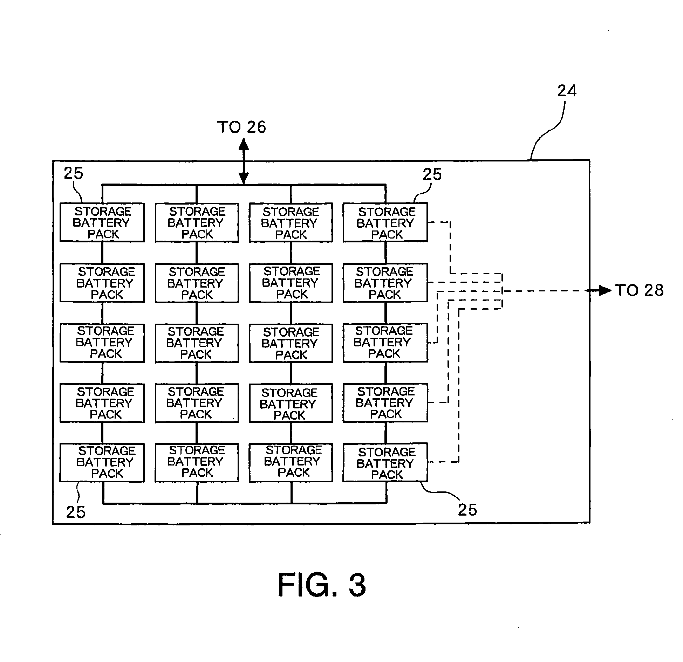

FIG. 3 shows an internal structure of the electricity storage section 24. The electricity storage section 24 is configured such that a plurality of storage battery packs 25 shown in FIG. 2 are connected in series and in parallel. More specifically, for example, the electricity storage section 24 is configured such that 5 storage battery packs 25 are connected in series and these 5 series connections are connected in 4 lines in parallel. The data from the pack information control section 25c of each storage battery pack 25, that is, a current value and a voltage value of each unit cell, a current value and a voltage value of each storage battery pack, a SOC of each storage battery pack, and the temperature of each storage battery pack, is output to the storage-battery-unit management section 28 via a communication line.

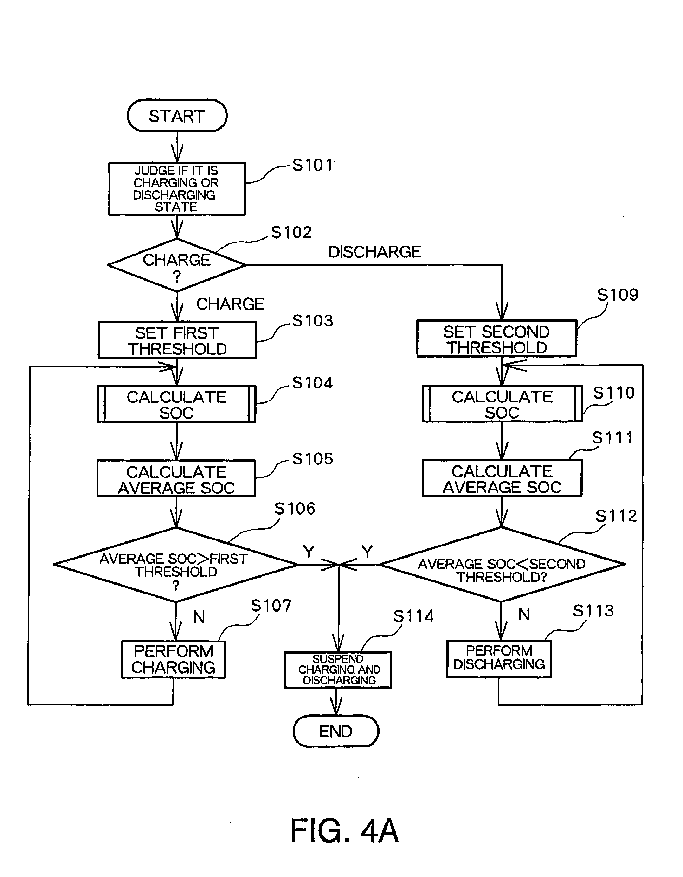

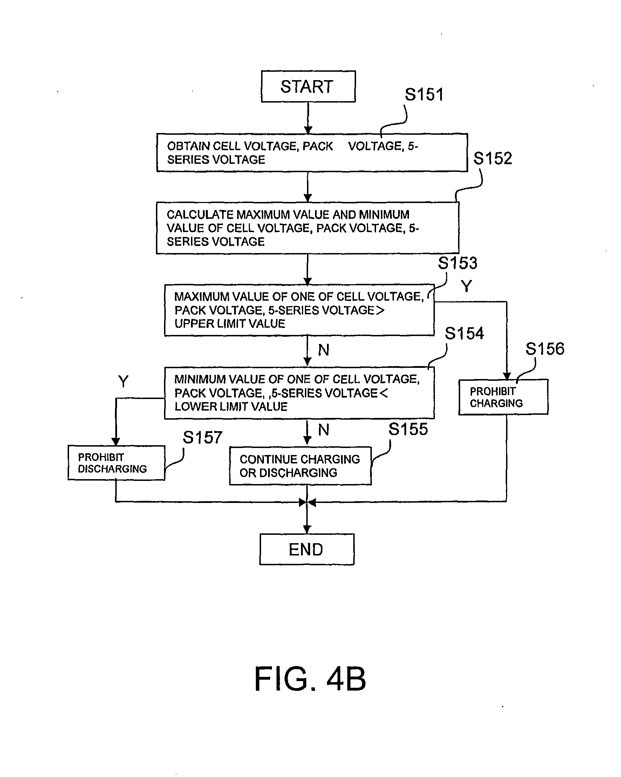

2. Basic Charge and Discharge Control of System Basic charge and discharge control of the system in the above structure will now be described. FIG. 4A and FIG. 4B show process flowcharts according to the present embodiment. FIG. 4A shows the process flowchart of charge and discharge control using an average value of the SOC, and FIG. 4B shows the process flowchart of charge and discharge control using cell voltage, pack voltage, and 5-series voltage. In the electrical power management system according to the present embodiment, charge and discharge control is carried out in parallel based on these two flowcharts, and the electrical power management system is configured to prohibit charging or discharging if charging becomes prohibited or discharging becomes prohibited in one of the flowcharts.

First, the process flowchart of charge and discharge control using an average value of the SOC shown in FIG. 4A will be described.

The system management section 18 judges whether to perform charging or discharging and outputs a charge and discharge control instruction to the total storage-battery-unit management section 16 (S101). Then, the total storage-battery-unit management section 16 judges whether the instruction is charging or discharging based on the charge and discharge control instruction (S102). In the following part, the charge instruction and the discharge instruction will be described separately.

### <Case of Charge Instruction>

If it is the charge instruction, the total storage-battery-unit management section 16 sets a first threshold in the storage-battery-unit management section 28 of each of the electricity storage units 22-1, 22-2, ..., and 22-5 (S103). In this process, a value higher than the average SOC which is calculated before charge is set as the first threshold. The first threshold is a target value of charging, and in the subsequent process, charge is carried out until the average SOC reaches the first threshold.

The total storage-battery-unit management section 16 obtains a SOC of each storage battery pack from the storage-battery-unit management sections 28 of the electricity storage units 22-1, 22-2, ..., and 22-5 (S104), and then calculates an average SOC of the storage battery system 22 (S105). The storage battery system 22 is composed of five electricity storage units 22-1, 22-2, ..., and 22-5, and if each electricity storage unit 22-1, 22-2, ..., and 22-5 is composed of 5-series, 4-parallel storage battery packs 25, data of a total of 5*5*4=100 SOCs are output from all storage-battery-unit management sections 28 to the total storage-battery-unit management section 16, and therefore, the total storage-battery-unit management section 16 calculates an average value of these data of 100 SOCs (average SOC), that is, the average SOC of all storage battery packs 25 in the storage battery system 22.

After the average SOC is calculated, the total storage-battery-unit management section 16 judges whether or not the calculated average SOC exceeds the first threshold (S106). If it is YES in S106, that is, when the average SOC exceeds the first threshold, the target value of charging is achieved, and charging is prohibited (S114).

On the other hand, if the average SOC is smaller than or equal to the predetermined first threshold, the total storage-battery-unit management section 16 performs charging (S107).

When the charging and discharging are to be executed while controlling the average SOC in a range of, for example, 30%-70%, the first threshold value may be set at 70%.

### <Case of Discharge Instruction>

If it is a discharge instruction, the total storage-battery-unit management section 16 sets a second threshold in the storage-battery-unit management sections 28 of the electricity storage units 22-1, 22-2, ..., and 22-5 (S109). Here, a value smaller than the average SOC which is calculated before discharge is set as the second threshold. The second threshold is a target value of discharging, and in the subsequent process, discharge is carried out until the average SOC reaches the second threshold.

The total storage-battery-unit management section 16 obtains a SOC for each storage battery pack from the storage-battery-unit management sections 28 of the electricity storage units 22-1, 22-2, ..., and 22-5 (S110), and then calculates an average SOC of all storage battery packs 25 of the storage battery systems 22 (S111).

After the average SOC is calculated, the total storage-battery-unit management section 16 judges whether or not the calculated average SOC is smaller than the second threshold (S112). The second threshold is a value smaller than the first threshold. If it is YES in S112, that is, when the average SOC is smaller than the second threshold, it is judged that discharging is not appropriate, and a discharge instruction is not carried out (S114).

On the other hand, if the average SOC is greater than or equal to the predetermined second threshold, the total storage-battery-unit management section 16 performs discharging (S113).

When the charging and discharging are to be executed while controlling the average SOC in a range of, for example, 30%-70%, the second threshold value may be set at 30%, and the lower limit value may be set at 10%. The voltage lower limit value may be set at a voltage value necessary for preventing overdischarge.

Next, the process flowchart of charge and discharge control using cell voltage, pack voltage, and 5-series voltage in FIG. 4B will be described. The cell voltage indicates a voltage of each unit cell 25a of the storage battery pack 25 shown in FIG. 2. The pack voltage indicates a voltage of the storage battery pack 25. The 5-series voltage indicates an overall voltage when the five storage battery packs 25 shown in FIG. 3 are connected in series. If 13 unit cells 25a are connected in series, cell voltage=pack voltage/13=5-series voltage/(13*5).

The total storage-battery-unit management section 16 obtains the cell voltage, the pack voltage, and the 5-series voltage from the storage-battery-unit management section 28 of each of the electricity storage units 22-1, 22-2, ..., and 22-5 (S151). Then, it calculates a maximum value and a minimum value of each of the cell voltage, the pack voltage, and the 5-series voltage (S152). If the storage battery system 22 is composed of five electricity storage units 22-1, 22-2, ...,and 22-5, and if each electricity storage unit 22-1, 22-2, ..., and 22-5 is composed of 5-series, 4-parallel storage battery packs 25, data of a total of 5*5*4=100 pack voltages are output from all storage-battery-unit management sections 28 to the total storage-battery-unit management section 16, and thus the total storage-battery-unit management section 16 calculates the maximum value and the minimum value of the data of these 100 SOCs. Similarly, the maximum value and the minimum value are calculated from a plurality of voltage values for each the cell voltage and the 5-series voltage.

After the maximum value and the minimum value of each of the cell voltage, the pack voltage, and the 5-series voltage are calculated, the total storage-battery-unit management section 16 judges whether or not the calculated maximum value of the voltage exceeds a predetermined voltage upper limit value (S153). If it is YES in S153, that is, when the maximum value exceeds the upper limit value, it is judged that charging is not appropriate, and charging is prohibited (S156). The prohibition of charging in S156 may be realized, for example, by setting a charge prohibition flag. Here, the charge prohibition flag may be the same flag as the charge prohibition flag used in the process flowchart shown in FIG. 4A, or may be provided as a different flag. The upper limit value may be set at 90%. The voltage upper limit value may be set at a voltage value necessary for preventing overcharge.

Next, the total storage-battery-unit management section 16 judges whether or not the calculated minimum value of the voltage is smaller than a voltage lower limit value (S154). If it is YES in S154, that is, when the minimum value is smaller than the lower limit value, it is judged that discharging is not appropriate, and discharging is prohibited (S157). The prohibition of discharging in S157 may be realized, for example, by setting a discharge prohibition flag. Here, the discharge prohibition flag may be the same flag as the discharge prohibition flag used in the process flowchart shown in FIG. 4A, or may be provided as a different flag. The lower limit value may be set at 10%. The lower limit value of the voltage may be set at a voltage value necessary for preventing overdischarge.

When the maximum value of each of the cell voltage, the pack voltage, and the 5-series voltage calculated by the total storage-battery-unit management section 16 does not satisfy the condition in S153, the charge prohibition flag or the discharge prohibition flag are not set, and the charging or discharging state is continued (S155). The process flowchart of FIG. 4B is executed at a regular interval such as, for example, once every second, to control charging and discharging.

There may be cases where an abnormality occurring in a series connection between the unit cells or an abnormality occurring in the series connection between the storage battery packs cannot be detected with the charge and discharge control using the average SOC of FIG. 4A alone. In consideration of this, by carrying out the charge and discharge control shown in FIG. 4B in parallel, the cell voltage, the pack voltage, and the 5-series voltage are independently compared with an upper limit value, and if any one of these values exceeds the voltage upper limit value, it is judged that an abnormality of some sort has occurred. Specifically, as shown in the flowchart in FIG. 4B, a common voltage upper limit value is used, and comparison is made between the maximum cell voltage and the voltage upper limit value, between the maximum pack voltage/13 and the voltage upper limit value, and between the 5-series voltage/(13*5) and the voltage upper limit value. When any of these values exceeds the voltage upper limit value, it is judged that there is a risk of overcharge, and charging is not performed. The upper limit values of the cell voltage, the pack voltage, and the 5-series voltage, for example, may be provided individually. For example, if the upper limit value of the cell voltage is set at 4.2V, then the upper limit value of the pack voltage and the 5-series voltage are set to be 53V and 250V, respectively.

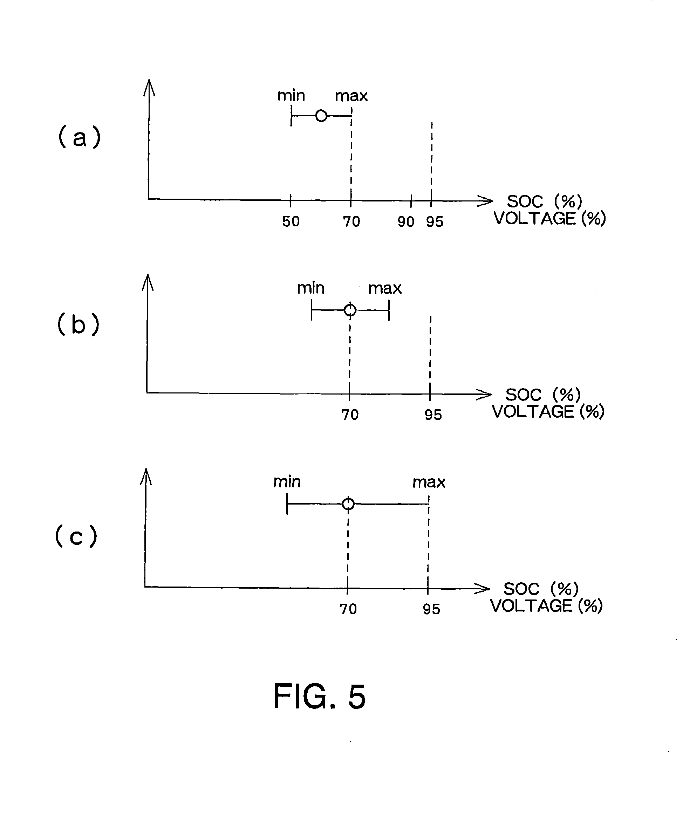

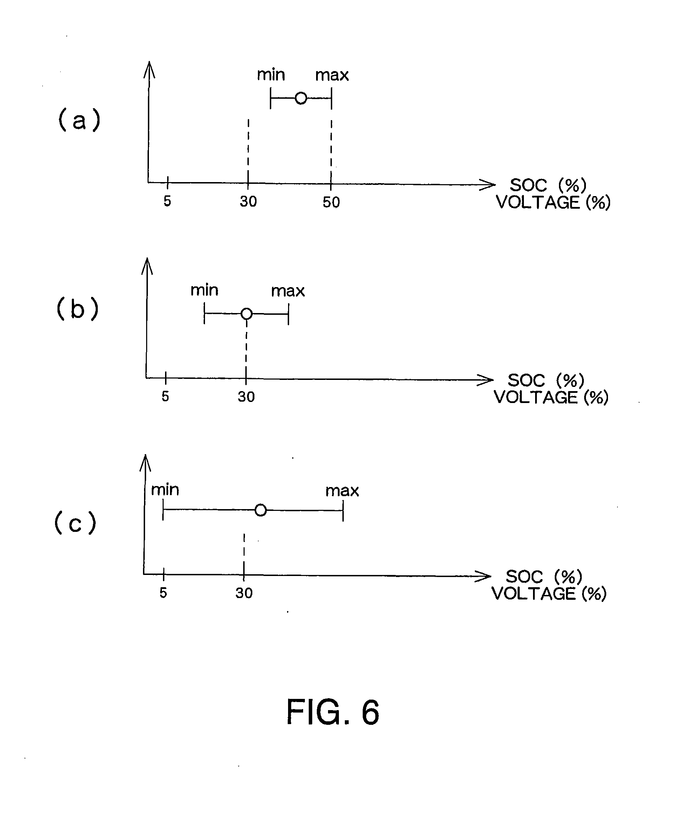

FIG. 5 and FIG. 6 show charging and discharging processes in time sequence. FIG. 5 shows a charging state, while FIG. 6 shows a discharging state. A maximum value and a minimum value of the pack voltage are used as examples. In both of the figures, max and min represent the maximum value of the pack voltage and the minimum value of the pack voltage, respectively, while a circle represents the average SOC. For the sake of convenience, the voltage value of the pack voltage is indicated as a percentage. First, FIG. 5 will be described. As shown in FIG. 5(a), if the average SOC is smaller than or equal to 70%, which is the first threshold, and if the maximum value of the pack voltage is smaller than or equal to 90%, which is the upper limit value, the charge instruction is executed, and the charging state is achieved.

When charging progresses and the SOC increases, to a state where the average SOC reaches the first threshold of 70% as shown in FIG. 5(b), charging is prohibited. In addition, as shown in FIG. 5(c), even if the average SOC has not reached the first threshold of 70%, when variation among the storage battery packs 25 increases and the maximum value of the pack voltage reaches of the upper limit value of 95%, charging is prohibited to prevent overcharge. Further, although not shown in the figure, when one of the maximum cell voltage and the maximum 5-series voltage reaches the voltage upper limit value, charging is prohibited at that point in time, even if the average SOC has not reached the first threshold of 70% and the maximum value of the pack voltage has not reached the upper limit value of 95%.

Next, FIG. 6 will be described. As shown in FIG. 6(a), if the average SOC is greater than or equal to 30%, which is the second threshold, and if the minimum value of the pack voltage is greater than or equal to 5% which is the lower limit value, the discharge instruction is executed, and the discharging state is achieved.

When discharging progresses, and the SOC decreases, to a state where the average SOC reaches the second threshold of 30% as shown in FIG. 6(b), discharging is prohibited. Further, as shown in FIG. 6(c), even if the average SOC has not reached the second threshold of 30%, when the variation among the storage battery packs 25 increases, and the minimum value of the pack voltage reaches the lower limit value of 5%, discharging is prohibited to prevent overdischarge. Further, although not shown in the figure, when one of the minimum cell voltage and the minimum 5-series voltage reaches the voltage lower limit value, discharging is prohibited at that point in time, even if the average SOC does not reach the second threshold of 30% and the minimum value of the pack voltage has not reached the lower limit value of 5%.

With these processes, it is possible to control charging and discharging such that the average SOC is within a range of 30% and 70%, and to prevent overcharge or overdischarge due to, for example, variations in characteristics among the storage battery packs 25 and defects in the storage battery packs 25 or in the serial connection between the storage batteries 25. Further, even if overcharge is not reached, when the storage battery pack 25 is left in a high voltage-charged state close to overcharge, the battery life is significantly shortened. With the above processes, the storage battery pack 25 can be prevented from being left in a high voltage state, so that degradation of the battery can be prevented, and the lifetime of the battery can be extended.

### 3. SOC Calculation Process

As described, the total storage-battery-unit management section 16 judges whether to execute the charge and discharge control instruction and implements charging or discharging. In the execution of charging or discharging, the SOC of the storage battery system 22 is calculated (S104 and S110 in FIG. 4A). Hereinafter, this SOC calculation process will be described in detail.

In general, as a method of calculating a SOC of the storage battery, the following two methods are known.

### (1) Method A

This is a calculation method based on an amount of current which flows in and out from the storage battery. When a current of greater than or equal to a certain amount flows, the amount of increase and decrease of the SOC can be calculated relatively accurately. Specifically, the SOC at a certain point in time is calculated by accumulating the charging current after that point in time over time and adding the result to the SOC, while accumulating the discharging current after that point in time over time and subtracting the result from the SOC. In this manner, the SOC at a desired point in time is calculated. However, with this method, a minute current which is smaller than or equal to the certain amount may not be detected. Therefore, there are the risks that the current may not be detected when charging is carried out in a constant voltage mode, etc., and that errors between the calculated value and the actual SOC will be accumulated. Similar influence may be caused by self-discharge in the storage battery, etc.

### (2) Method B

This is a calculation method based on a function of parameters of an open-end voltage of the storage battery and the temperature. Specifically, as there is a certain correlation between the open-end voltage and the temperature and the SOC, the relationship between the open-end voltage and the temperature and the SOC is stored in a memory in the form of a function or a table in advance, and the open-end voltage and the temperature at a certain point in time are detected, thereby calculating a SOC corresponding to the detected results. If the SOC is greater than or equal to a certain value, and the temperature is about room temperature, the influence of the temperature on the SOC is smaller than the open-end voltage and may be ignored, and thus, the open-end voltage may be set as the only parameter. Because this relationship may change depending on degradation of the storage battery or the memory effect, updating the relationship regularly is also proposed. With this method, it is possible to calculate a SOC using any voltage and current. However, it is difficult to estimate the open-end voltage during charge and discharge operations, and it is also difficult to estimate the open-end voltage accurately because there is influence of hysteresis immediately after the start of charge or discharge and immediately after transition from the charging or discharging state to the waiting state (even when a current changes, voltage does not follow immediately and changes slowly).

As such, because both Method A and Method B have advantages and disadvantages, as the storage battery system 22 is charged and discharge repeatedly, it becomes difficult to calculate the SOC accurately with one of these methods alone. Consequently, it becomes impossible to carry out charge and discharge control accurately.

In consideration of this, in the present embodiment, the SOC is calculated by combining both methods. Specifically, in consideration of the fact that, in the management system of the present embodiment, the system management section 18 outputs the charge and discharge control instruction irregularly to make the transition among three states, that is, the charging state, the discharging state, and the waiting state, as described above, Method A is used to calculate the SOC in the charging state and the discharging state such that the accumulated value of the charging or discharging current during the charging or discharging period is added to or subtracted from the current SOC. In addition, if the waiting state continues for more than a certain period of time, Method B is used to calculate the SOC in consideration of the fact that there is no influence of hysteresis and the SOC can be calculated accurately with the error corrected.

When the SOC is calculated using Method B during charging or discharging, if the open-end voltage is measured during charging or discharging of the storage battery system 22, the open-end voltage may not be measured accurately, and the SOC may therefore be calculated accurately. Therefore, in order to calculate the SOC while the storage battery system 22 is being charged or discharged, it is preferable to suspend the charging or discharging process and resume the charging or discharging process after the SOC is calculated. The suspension of charging process during charging is fine, but if the discharging process is suspended during discharging, there is a risk that power to be supplied to the load will become insufficient. Therefore, in this case, it is preferable to supply power from the external commercial power supply 10 to the load to compensate electrical power. The external commercial power supply 10 may also be used as a backup power supply during suspension.

Method A can be implemented in the parameter calculation section 25b of each storage battery pack 25 to calculate the SOC. The calculated SOC for each storage battery pack 25 is supplied to the total storage-battery-unit management section 16, as described above. By storing a function or a table representing the relationship between open-end voltage and temperature and the SOC in the memory of the total storage-battery-unit management section 16 in advance, Method B may be implemented by the total storage-battery-unit management section 16 to calculate the SOC. The total storage-battery-unit management section 16 switches between Method A and Method B, to thereby calculate a SOC.

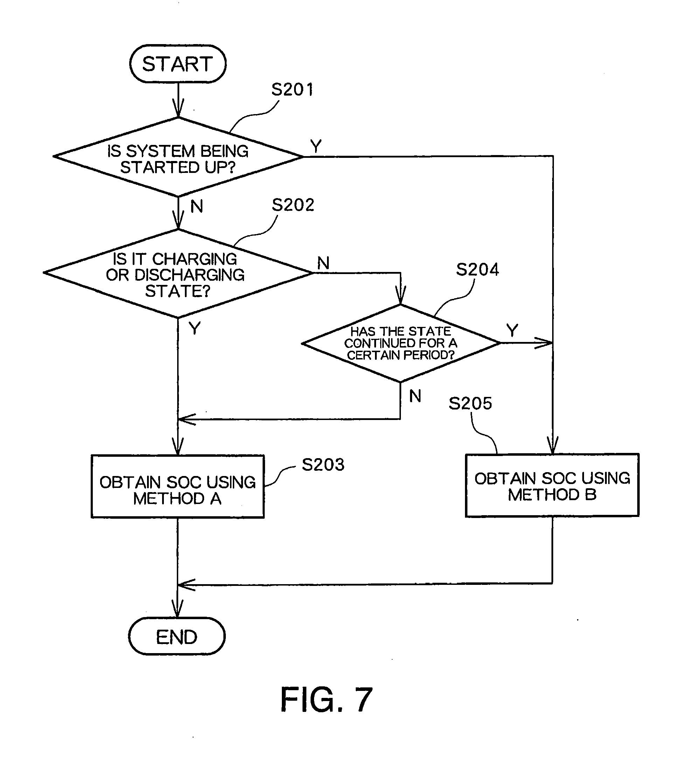

FIG. 7 shows a flowchart of the SOC calculation process according to the present embodiment. The total storage-battery-unit management section 16 first judges whether or not the electrical power management system is being started up (S201). If the system is being started up, the total storage-battery-unit management section 16 calculates the SOC by Method B (S205). The SOC calculated at the startup of the system is used as a reference value for subsequent calculation of SOC, as the SOC initial value.

If the system is not being started up, then whether the storage battery system 22 is in the charging state or the discharging state is judged (S202). It is judged to be YES when the charge instruction or the discharge instruction is being executed, and the total storage-battery-unit management section 16 calculates the SOC using Method A (S203). That is, the total storage-battery-unit management section 16 accumulates the charging or discharging current value until suspension, and adds or subtracts the accumulated value to or from the SOC calculated by Method B, to thereby calculate the SOC.

On the other hand, if it is judged in S202 that the system is neither in the charging state nor the discharging state, that is, if the system is in the waiting state, the total storage-battery-unit management section 16 then judges whether or not this waiting state has continued for a certain period of time (S204). If the waiting state has not continued for the certain period of time, it is judged that there is still influence of the hysteresis, and therefore, Method A is used to calculate the SOC (S203). If it is judged that the waiting state has continued for the certain period of time, it is then judged that there is no influence of the hysteresis, that the change of voltage follows the change of current, and that the open-end voltage can be detected relatively accurately. Thus, Method B is used to calculate the SOC (S205). Because the method of calculating the open-end voltage is known, and there is the relation V=Vo +IR among the internal resistance R, the output voltage V, the open-end voltage Vo, and the discharging current I, the open-end voltage Vo may be calculated by detecting pair data of (I, V) and plotting them. The calculation of the SOC using the open-end voltage Vo is also disclosed in, for example, JP 2006-194789 A assigned to the present assignee.

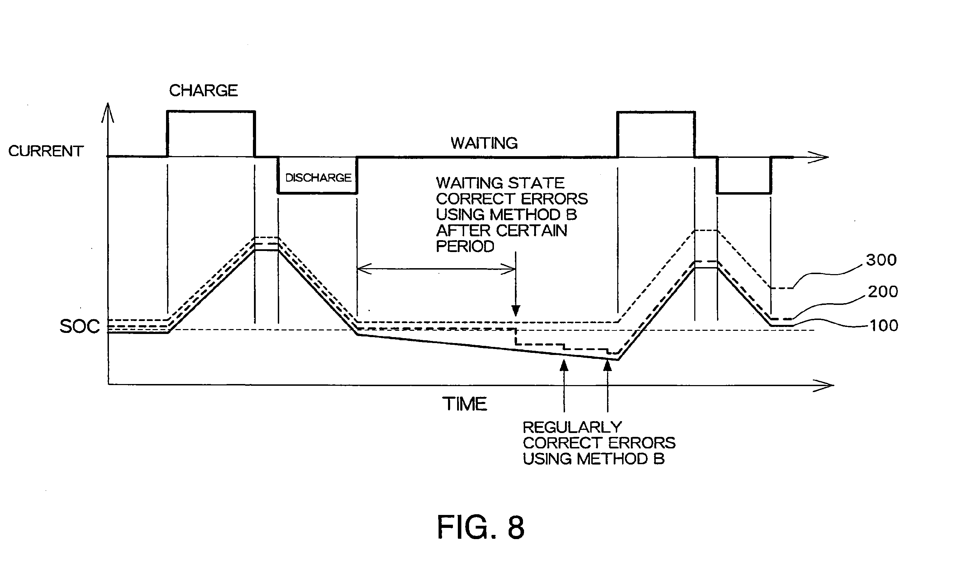

FIG. 8 shows the SOC calculation process in the present embodiment in time sequence. In the figure, a reference numeral 100 indicates a change of the actual SOC over time; a reference numeral 200 indicates a change of the SOC calculated in the present embodiment over time; and a reference numeral 300 indicates a change of the SOC calculated over time using Method A alone, for the purpose of comparison. In the charging process or the discharging process, the SOC is calculated using Method A by suspending the charging process or the discharging process. In this case, the SOC may be calculated relatively highly precisely and there is almost no error from the actual SOC.

However, when the system transits to the waiting state, although the actual SOC gradually decreases due to self-discharge, etc., it is judged that there is no change in the SOC in the waiting state with Method A alone, and therefore errors from the actual SOC are accumulated. On the other hand, in the present embodiment, if the waiting state continues for a certain period of time, the method is switched to Method B from Method A to calculate the SOC, and therefore, the error from the actual SOC can be corrected.
If the waiting state continues further, the SOC is calculated repeatedly using Method B.

When the waiting state is completed, and the charging process or the discharging process is executed, the SOC is again calculated using Method A.

As is clear from FIG. 8, in the present embodiment, it is possible to obtain the SOC which is almost equal to the actual SOC because, during the charging process or the discharging process, the SOC is calculated by suspending the charging process or the discharging process, and if the waiting state continues for a certain period of time, the method is switched to Method B to calculate and correct the SOC.

### 4. Modifications

Although the embodiment of the present invention has been described, the present invention is not limited to this, and various modifications may be employed.

For example, in the present embodiment, it is possible to use a solar battery (solar photovoltaic power generation system), etc. as a power source, in addition to the external commercial power supply 10. Electrical power generated in the solar battery is supplied to the storage battery system 22 to thereby charge the storage battery system 22. In this case, it is also preferable to suspend the charging and the discharging process in order to calculate a SOC using Method A. When the discharging process is suspended, the solar battery may be used as the backup power supply.

In addition, although, in the present embodiment, an average SOC of all the storage battery packs 25 in the storage battery system 22 is calculated and this average SOC is compared with the first threshold or the second threshold, it is also possible to calculate an average voltage of all the storage battery packs 25 in the storage battery system 22, and compare the average voltage with a first threshold or a second threshold, in place of the average SOC.

Alternatively, it is also possible to calculate the average SOC and the average voltage of all storage battery packs 25 in the storage battery system 22, and prohibit the charging process when at least one of the average SOC and the average voltage exceeds the first threshold or the first voltage threshold, and prohibit the discharging process when at least one of the average SOC and the average voltage is smaller than the second threshold or the second voltage threshold.

Further, although, in the present embodiment, charging is prohibited when the maximum SOC exceeds the upper limit value, and discharging is prohibited when the minimum SOC is smaller than the lower limit value, it is also possible to use the maximum voltage of all storage battery packs 25 in place of the maximum SOC, and use the minimum voltage of all storage battery packs 25 in place of the minimum SOC.

In addition, although, in the present embodiment, charging is prohibited when at least one of the maximum cell voltage, the maximum pack voltage, and the maximum 5-series voltage exceeds the voltage upper limit value, and discharging is prohibited when at least one of the minimum cell voltage, the minimum pack voltage, and the minimum 5-series voltage is smaller than the voltage lower limit value, it is also possible to combine a desired two of the cell voltage, the pack voltage, and the 5-series voltage for overcharge protection or overdischarge protection. For example, the cell voltage and the 5-series voltage may be combined, cell voltage and the pack voltage may be combined, and the pack voltage and the 5-series voltage may be combined. If the cell voltage and the 5-series voltage are used, in the process of S153 in FIG. 4B, , it is judged whether or not one of the maximum cell voltage and the maximum 5-series voltage exceeds the voltage upper limit value, and if it exceeds the limit value, the charging process is prohibited. Further, in the process of S154 in FIG. 4B, it is judged whether or not one of the minimum cell voltage and the minimum 5-series voltage is smaller than the voltage lower limit value, and if it is smaller than the limit value, the discharging process is prohibited.

Moreover, although, in the present embodiment, as the state of charge of the storage battery pack 25, a relative charge percentage SOC (%) with respect to a fully charged state 100 is used, a remaining capacity value (A*h) may be used in place of the charge percentage SOC (%).

### Reference Numerals List

10 external commercial power supply, 12 PCS integration board, 14 power conditioner, 16 overall storage-battery-unit management section, 18 system management section, 20 overall power monitoring device, 22 storage battery system, 24 electricity storage section, 25 storage battery pack, 26 power-system switching circuit, 28 storage-battery-unit management section

## Claims

1. An electrical power management system for controlling charging and discharging of an electricity storage section which is charged with power from a power source and discharges the stored power to a load, wherein:
the electricity storage section comprises a plurality of storage battery packs connected to each other in series;
the storage battery pack comprises a plurality of unit cells connected to each other in series; and
the electrical power management system comprises:
a detection section which detects voltages of the unit cells and voltages of the storage battery packs; and
a control section which compares the detected voltages of the unit cells and the detected voltages of the storage battery packs with upper limit values and lower limit values, and suspends a charging process of the electricity storage section when at least one of the voltages of the unit cells and the voltages of the storage battery packs exceeds the upper limit values, and suspends a discharging process of the electricity storage section when at least one of the voltages of the unit cells and the voltages of the storage battery packs is smaller than the lower limit values.

2. The electrical power management system according to Claim 1, wherein:
the storage battery pack comprises m (m is an integer greater than or equal to 2) unit cells connected to each other in series; and
the control section compares the voltages of the unit cells with the upper limit value and the lower limit value, and compares a voltage which is obtained by dividing the voltages of the storage battery packs by m with the upper limit value and the lower limit value.

3. An electrical power management system for controlling charging and discharging of an electricity storage section which is charged with power from a power source and discharges the stored power to a load, wherein:
the electricity storage section comprises a plurality of storage battery packs connected to each other in series;
the storage battery pack comprises a plurality of unit cells connected to each other in series; and
the electrical power management system comprises:
a detection section which detects voltages of the unit cells and a series voltage of the storage battery packs connected in series; and
a control section which compares the detected voltages of the unit cells and the detected series voltage with upper limit values and lower limit values, and suspends a charging process of the electricity storage section when at least one of the voltages of the unit cells and the series voltage exceeds the upper limit values, and suspends a discharging process of the electricity storage section when at least one of the voltages of the unit cells and the series voltage is smaller than the lower limit values.

4. The electrical power management system according to Claim 3, wherein:
the electricity storage section comprises n (n is an integer greater than or equal to 2) storage battery packs connected to each other in series, and the storage battery pack comprises m (m is an integer greater than or equal to 2) unit cells connected to each other in series; and
the control section compares the voltages of the unit cells with the upper limit value and the lower limit value, and compares a voltage which is obtained by dividing the series voltage by m*n with the upper limit value and the lower limit value.

5. An electrical power management system for controlling charging and discharging of an electricity storage section which is charged with power from a power source and discharges the stored power to a load, wherein:
the electricity storage section comprises a plurality of storage battery packs connected to each other in series;
the storage battery pack comprises a plurality of unit cells connected to each other in series; and
the electrical power management system comprises:
a detection section which detects voltages of the storage battery packs and a series voltage of the storage battery packs connected in series; and
a control section which compares the detected voltages of the storage battery packs and the detected series voltage with upper limit values and lower limit values, and suspends a charging process of the electricity storage section when at least one of the voltages of the storage battery packs and the series voltage exceeds the upper limit values, and suspends a discharging process of the electricity storage section when at least one of the voltages of the storage battery packs and the series voltage is smaller than the lower limit values.

6. The electrical power management system according to Claim 5, wherein:
the electricity storage section comprises n (n is an integer greater than or equal to 2) storage battery packs connected to each other in series, and the storage battery pack comprises m (m is an integer greater than or equal to 2) unit cells connected to each other in series; and
the control section compares a voltage which is obtained by dividing the voltages of the storage battery packs by m with the upper limit value and the lower limit value, and compares a voltage which is obtained by dividing the series voltage by m*n with the upper limit value and the lower limit value.

7. An electrical power management system for controlling charging and discharging of an electricity storage section which is charged with power from a power source and discharges the stored power to a load, wherein:
the electricity storage section comprises a plurality of storage battery packs connected to each other in series;
the storage battery pack comprises a plurality of unit cells connected to each other in series; and
the electrical power management system comprises:
a detection section which detects voltages of the unit cells, voltages of the storage battery packs, and a series voltage of the storage battery packs connected in series; and
a control section which compares the detected voltages of the unit cells, the detected voltages of the storage battery packs, and the detected series voltage with upper limit values and lower limit values, and suspends a charging process of the electricity storage section when at least one of the voltages of the unit cells, the voltages of the storage battery packs, and the series voltage exceeds the upper limit values, and suspends a discharging process of the electricity storage section when at least one of the voltages of the unit cells, the voltages of the storage battery packs, and the series voltage is smaller than the lower limit values.

8. The electrical power management system according to Claim 7, wherein:
the electricity storage section comprises n (n is an integer greater than or equal to 2) storage battery packs connected to each other in series, and the storage battery pack comprises m (m is an integer greater than or equal to 2) unit cells connected to each other in series; and
the control section compares the voltages of the unit cells with the upper limit value and the lower limit value, compares a voltage which is obtained by dividing the voltages of the storage battery packs by m with the upper limit value and the lower limit value, and compares a voltage which is obtained by dividing the series voltage by m*n with the upper limit value and the lower limit value.
